Europäisches Patentamt

European Patent Office

Office européen des brevets

(11) Publication number: **0 082 736**
**B1**

## (12) EUROPEAN PATENT SPECIFICATION

(45) Date of publication of patent specification: **01.03.89**

(21) Application number: **82307049.5**

(22) Date of filing: **22.12.82**

(51) Int. Cl.⁴: $H\ 03\ M\ 1/00$

(54) Analogue to digital converter.

(30) Priority: **22.12.81 JP 207399/81**

(43) Date of publication of application:
**29.06.83 Bulletin 83/26**

(45) Publication of the grant of the patent:
**01.03.89 Bulletin 89/09**

(84) Designated Contracting States:
**AT DE FR GB NL**

(56) References cited:
**EP-A-0 070 734**
**GB-A-2 012 135**
**US-A-3 636 555**
**US-A-3 846 786**

**IEEE JOURNAL OF SOLID-STATE CIRCUITS,
vol. SC-15, no. 3, June 1980, pages 286-290,
IEEE, New York, US; P.H.SAUL et al.:
"Monolithic components for 100 MHz data
conversion"**

(73) Proprietor: **SONY CORPORATION**
**7-35 Kitashinagawa 6-Chome Shinagawa-ku
Tokyo 141 (JP)**

(72) Inventor: **Sekino, Takeo**
**1-3-402 Tobio 3-chome
Atsugi-shi Kanagawa-ken (JP)**
Inventor: **Takeda, Masashi**
**1-373, Sakuradai
Isehara-shi Kanagawa-ken (JP)**

(74) Representative: **Ayers, Martyn Lewis Stanley
et al
J.A. KEMP & CO. 14 South Square Gray's Inn
London, WC1R 5EU (GB)**

## Description

This invention relates to an analog-to-digital converter, and more particularly, to a compact, high speed analog-to-digital converter.

Prior art high speed analog-to-digital (A/D) converters can generally be classified as either parallel-type converters or serial-type converters. Parallel type A/D converters which convert an analog input signal to, for example, 8 bits digital output signals generally require 255 complex voltage comparing circuits connected in parallel. These circuits require a large number of devices resulting in high power consumption and in a big tip-size IC (Integrated Circuit). Serial-to-parallel A/D converters having an output of m upper bits and n lower bits which convert an analog input signal to 8 bits digital output signals require 30 complex voltage comparing circuits and have low power consumption, and result in a small tip-size IC. However, this serial-to-parallel A/D converter requires a digital-to-analog converter and subtractor for A/D converting the upper bits and lower bits separately, so that it is difficult to convert the analog input signal to digital output signal exactly. It is feared, for example, that the serial-to-parallel A/D converter produces non-sequential values when converting a monotonically increasing analog input signal to a digital signal.

EP—A—0070734 (published 26.01.1983) discloses an analog-to-digital converter having fewer comparators for a given resolution than previous ones. It is for converting an analog input signal to a digital output signal with m upper bits and n lower bits having $(2^{m+n}-1)$ resistor means connected in a series circuit to establish respective reference voltages, comprising $(2^m-1)$ upper bits comparator circuits having first input terminals connected to receive said analog input signal and second input terminals connected to said series circuit of resistor means at $2^n$ intervals defining $2^n$ groups of resistor means therebetween; upper bits encoder means connected to receive said output signals of said $(2^m-1)$ upper bit(s) comparator circuits for generating said m upper bits.

The invention is directed to a further improved A/D converter and provides an analog-to-digital converter for converting an analog input signal to a digital output signal with m upper bits and n lower bits having $(2^{m+n}-1)$ resistor means connected in a series circuit to establish respective reference voltages, comprising $(2^m-1)$ upper bits comparator circuits having first input terminals connected to receive said analog input signal and second input terminals connected to said series circuit of resistor means at $2^n$ intervals defining $2^n$ groups of resistor means therebetween; upper bits encoder means connected to receive said output signals of said $(2^m-1)$ upper bit(s) comparator circuits for generating said m upper bits wherein lower bits encoder means connected to a lower bits matrix comparator circuit for generating said n lower bits, a lower bits matrix comparator circuit having $2^m(2^n-1)$ comparators having first input terminals which are connected to receive said analog input signal and second input terminals which are connected to respective nodes of said series circuit of resistor means except for a plurality of nodes of said resistor means to which said second input terminals of said $(2^m-1)$ upper bit(s) comparators are connected.

As will become apparent from the following description of an illustrative embodiment, the invention can provide an analog-to-digital converter which does not have the aforesaid problems of the prior art analog-to-digital converters, which can be made as a compact integrated circuit, and is capable of high speed conversion while having a relatively low power consumption.

The invention will be further described by way of non-limitative example with reference to the accompanying drawings, in which;

Figs. 1A, 1B, 1C, 1D, 2A, 2B, 2C and 2D illustrate an embodiment of analog-to-digital converter according to the present invention;

Fig. 3, Fig. 4A and 4B are truth tables of encoders illustrated in Figs. 1A, 1B, 1C, 1D and Figs. 2A, 2B, 2C and 2D; and

Fig. 5 illustrates another embodiment of the present invention.

High speed analog-to-digital (A/D) converters are in general of parallel type or serial-parallel type.

The parallel type A/D converter requires 255 voltage comparators of complex arrangement for converting an analog input voltage to a digital output of, for example, 8 bits. This causes the number of circuit elements to increase so that power consumption is increased and also a chip size of the A/D converter is enlarged when formed as an integrated circuit (IC).

On the other hand the A/D converter of serial-parallel type requires only 30 voltage comparators for converting the analog input voltage to an 8-bit digital output thus reducing power consumption and the chip size thereof when made as an IC. However, this serial-parallel type A/D converter requires the use of a digital-to-analog (D/A) converter and individually A/D-converts upper and lower bits of the digital outputs so that it is difficult to obtain precision A/D conversion. For example, when the analog input voltage increases monotonically the digital output does not increase monotonically and hence there are caused dips and peaks in the transfer function.

The illustrated embodiments of this invention provide A/D converters which can obviate the aforesaid defects with relatively few circuit elements.

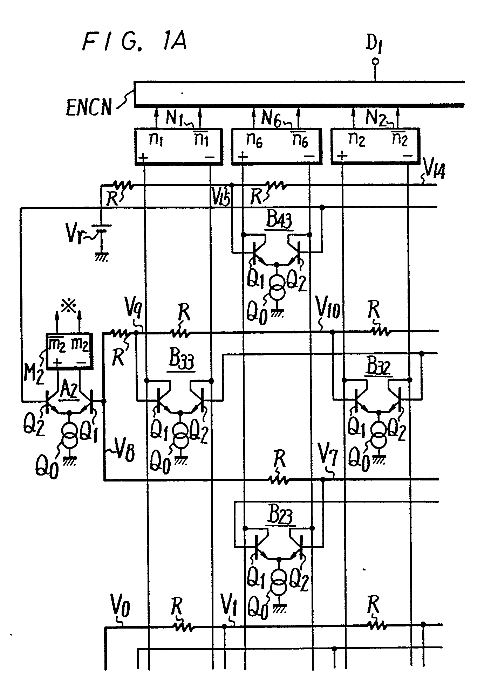

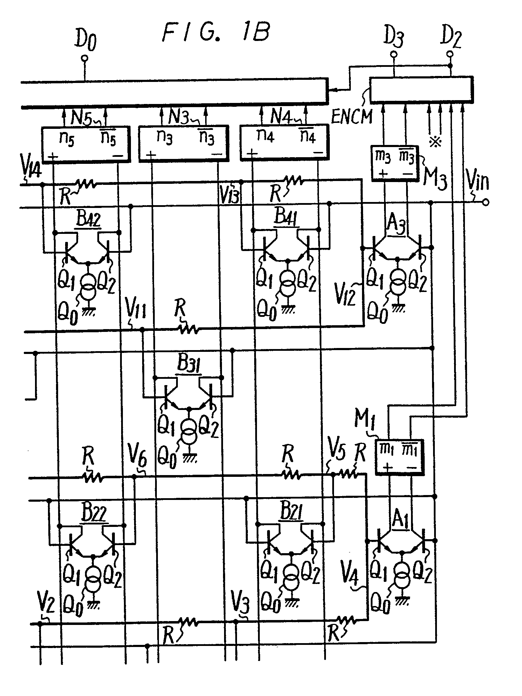

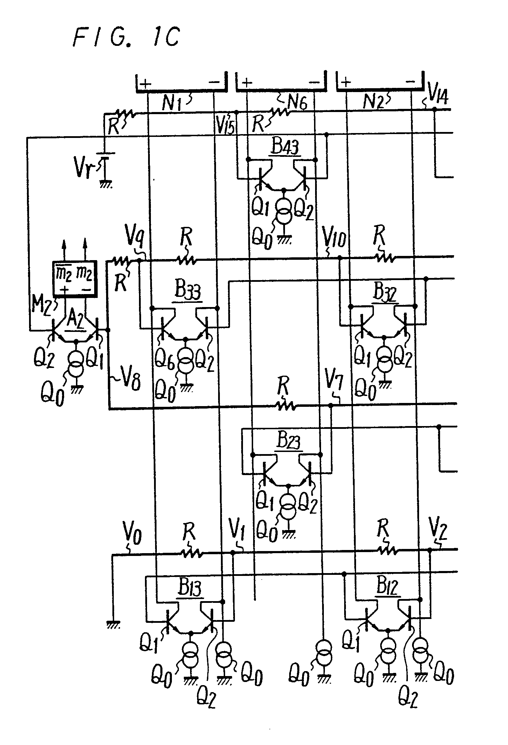

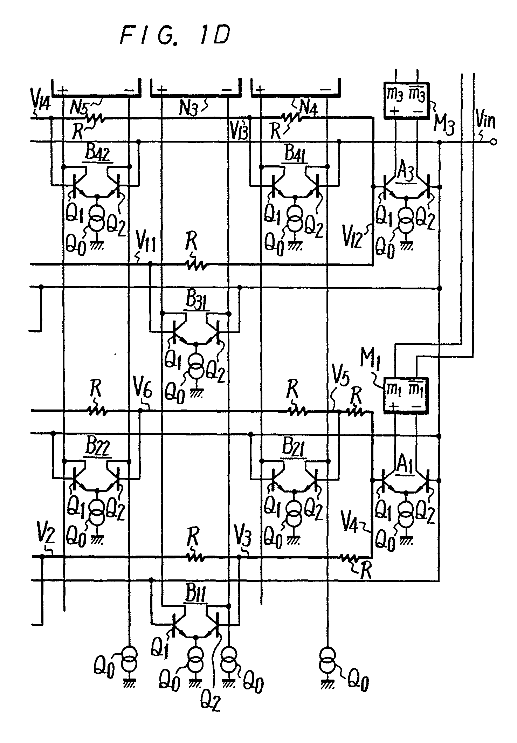

An embodiment of this invention will hereinafter be described with reference to Fig. 1. In this embodiment of Fig. 1, an analog input voltage Vin is converted to a digital output D3 to D0 of 4 bits. Fig. 1 is formed of Figs. 1A through 1D for ease of drawing (the connected parts thereof should be overlapped).

In Fig. 1, for upper bits D3 and D2 of the digital output D3 to D0, there are provided three pairs of three voltage comparators M3 to M1 and A3 to A1. In this case, each of the voltage comparators A3 to A1 is formed such that it comprises transistors Q1 and Q2 the emitters of which are connected together to a constant current source Q0 and the collectors of which are connected to inputs of the voltage comparators M3 to M1. The comparators A3 to A1 inherently function as the first stages of the comparators M3 to M1.

For lower order bits D1 and D0 of the digital output D3 to D0, there are provided 6 voltage comparators N6 to N1, and voltage comparators Bij (i=4 to 1 and j=3 to 1) as a matrix therefor. Each of the voltage comparators Bij comprises transistors Q1 and Q2 the emitters of which are connected together to constant current sources Q0. The collectors of the transistors Q1 and Q2 in the comparators B3j and B1j are connected to the inputs of the comparators N1 to N3, while the collectors of the transistors Q1 and Q2 in the comparators B4j and B2j are connected to the inputs of the comparators N6 to N4. Constant current sources Q0 are respectively connected to the collectors of the transistors Q2 in the comparators Bij. The comparators Bij inherently function as the first stages of the comparators N6 to N1.

16 resistors R of substantially the same resistance value are connected in series between a reference voltage source Vr and ground as a resistor chain to generate reference voltages V15 to V0 in 16 steps. Of these reference voltages V15 to V0, every fourth step, ie the voltages V12, V8 and V4 are respectively supplied to the bases of the transistors Q1 in the comparators A3 to A1. The voltages V15 to V13 and V11 to V9 are respectively supplied to the bases of the transistors Q1 of the comparators B43 to B41 and B31 to B33 and the remaining voltages V7 to V5 and V3 to V1 are respectively supplied to the bases of the transistors Q2 in the comparators B23 to B21 and B11 to B13. The analog input voltage Vin is supplied to the bases of the transistors Q2 in the comparators A3 to A1 and the bases of the transistor Q1 and Q2 in the comparators Bij to which up to this point particular ones of the voltages V15 to V1 have not been mentioned as being supplied.

The magnitude of the constant current derived from each of the constant current source Q0 for the comparators A3 to A1 and Bij as I0.

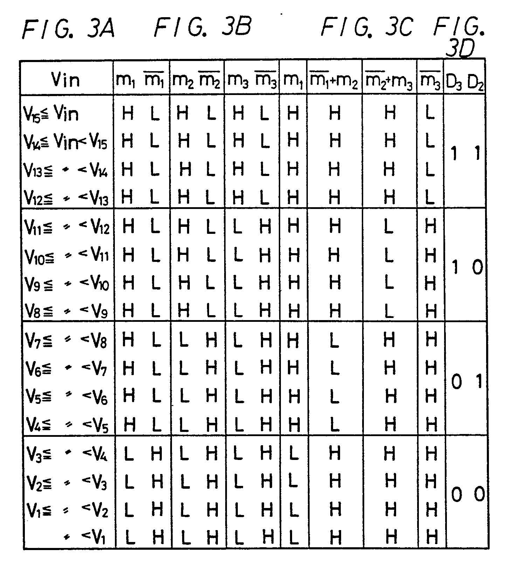

Output signals m1, $\overline{m1}$ to m3, $\overline{m3}$ from the comparators M1 to M3 are supplied to an upper-bit encoder ENCM in which as shown in Fig. 3C, the signals m1 to $\overline{m3}$ are calculated by use of OR logic function and the encoding shown in Fig. 3D is carried out in association with the above signals thereby yielding the upper bits D3 and D2.

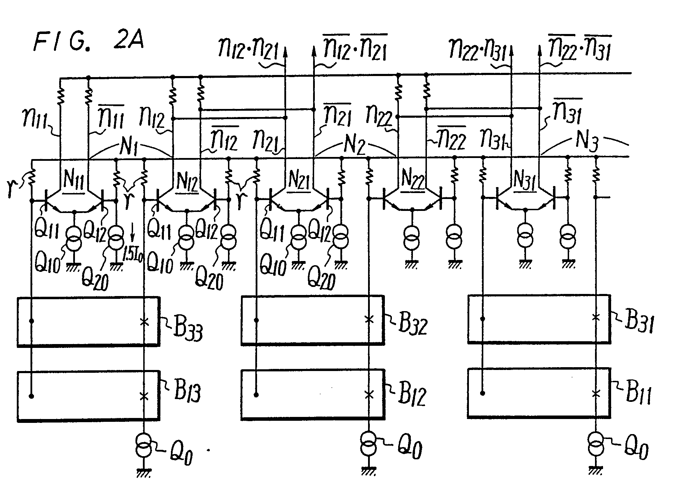

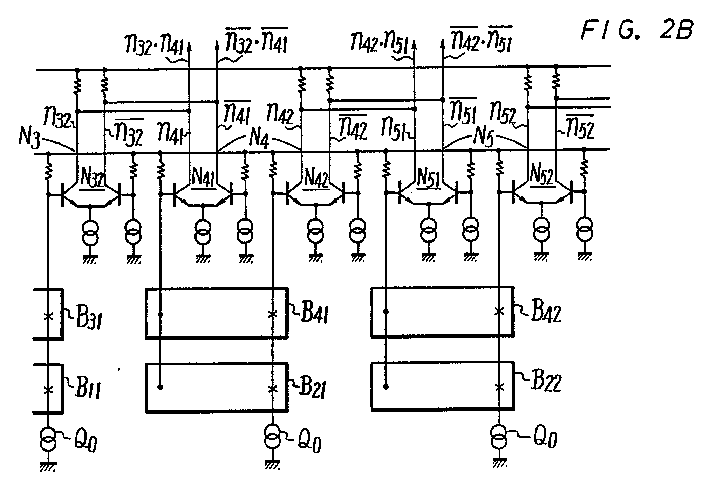

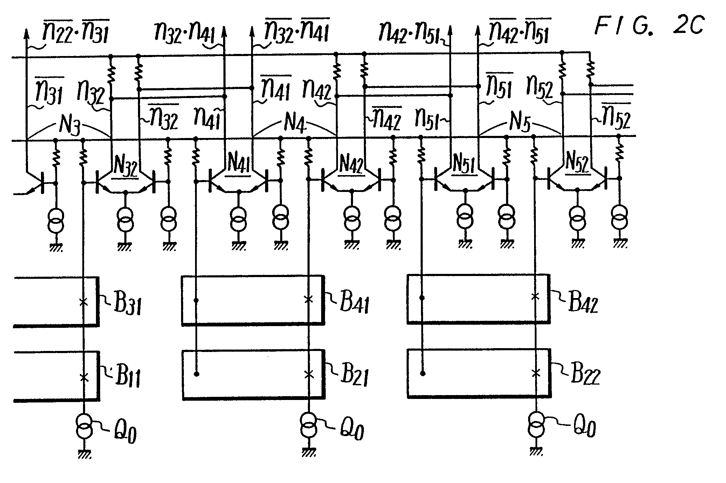

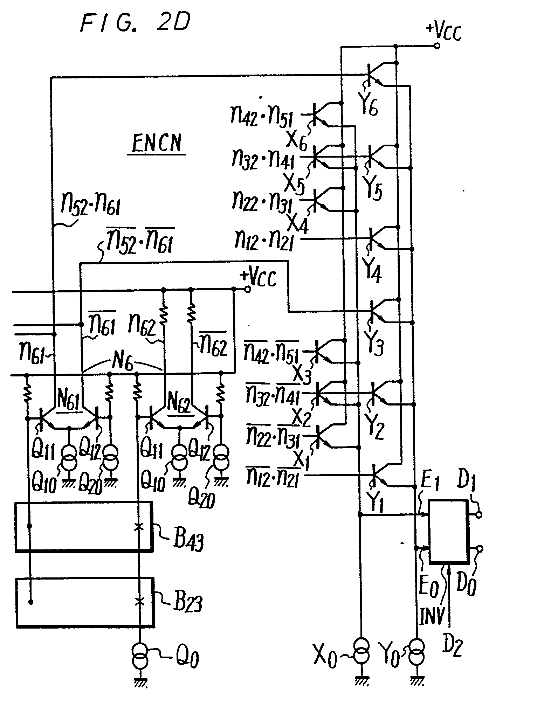

The comparators N1 to N6 and a lower-bit encoder ENCN are arranged as, for example, shown in Fig. 2.

Fig. 2 is also formed of Figs. 2A through 2D. In Fig. 2, the comparators Bij are each shown in block form in which marks . represent the collectors of the transistors Q1 and marks X represent the collectors of the transistors Q2, respectively.

Each of comparators Nk (k=1 to 6) is composed of two voltage comparators Nk1 and Nk2, and each of the comparators Nk1 and Nk2 comprises transistors Q11 and Q12 the emitters of which are connected together to a constant current source Q10. The transistors Q11 in the comparators Nk1 and Nk2 are connected at the bases thereof with the collectors of the transistors Q1 (marked by .) and the collectors of the transistors Q2 (marked by X) of the comparators B33, B13; B32, B12; B31, B11; B41; B21; B42, B22; and B43, B23, respectively. The bases of transistors Q12 in the comparators Nk1 and N12 are connected to respective constant current sources Q20. Resistors r are connected between the bases of all the transistors Q11 and Q12 and voltage terminals, respectively. The magnitude of the constant current from the constant current source Q20 is selected as, for example, 1.5 I0.

The encoder ENCN comprises transistors X1 to X6 the emitters of which are connected together to a constant current source X0 and transistors Y1 to Y6 the emitters of which are connected together to a constant current source Y0. If, now, the collector outputs from the transistors Q11 in the comparators Nk1 and N12 are taken as signals nk1 and nk2 and the collector outputs from the transistors Q12 therein are taken as signals $\overline{nk1}$ and $\overline{nk2}$, respectively, these signals are calculated in the manner of wired-AND logic to yield AND signals as:

$$n12 \cdot n21, \overline{n12} \cdot \overline{n21}$$

$$n22 \cdot n31, \overline{n22} \cdot \overline{n31}$$

$$n32 \cdot n41, \overline{n32} \cdot \overline{n41}$$

$$n42 \cdot n51, \overline{n42} \cdot \overline{n51}$$

$$n52 \cdot n61, \overline{n52} \cdot \overline{n61}$$

These AND signals are supplied to the bases of the transistors X1 to X6 and Y1 to Y6 with the relation as shown in Fig. 2.

Emitter outputs E1 and E0 from the transistors X1 to X6 and Y1 to Y6 are supplied to a level control circuit INV which produces the lower bits D1 and D2 that can be represented as $\overline{E1}$ and $\overline{E0}$ when D2="1" and E1 and E0 when D2="0".

The generation of the upper bits D3 and D2 will now be described. The comparator A1, for example, is supplied with the voltage V4 as a reference voltage thereof so that when the analog input voltage Vin is smaller than the reference voltage V4 (Vin V4), the transistor Q1 in the comparator A1 is turned ON but the transistor Q2 therein is turned OFF, thus achieving m1="L" and $\overline{m1}$="H" as shown in the 1st to 4th rows from the bottom in Figs. 3A and 3B. When the reference voltage V4 is smaller than or equal to the analog voltage Vin (V4≦Vin), the transistor Q1 is turned OFF but the transistor Q2 is turned ON in the comparator A1 so that as shown in the 2nd to 13th rows from the top in Figs. 3A and 3B, m1="H" and $\overline{\text{M1}}$="L" are established. The comparators A2 and A3 are respectively supplied with the reference voltages V8 and V12 so that the input voltage Vin and the signals m2 to $\overline{\text{m3}}$ are given as shown in Figs. 3A and 3B.

Accordingly, since the input voltage Vin and the logic and encoding of the encoder ENCM are as shown in Figs. 3A and 3C, the upper bits D3 and D2 of the digital output are generated in association with the input voltage Vin as shown in Fig. 3D.

Next, the generation lower bits D1 and D0 will be described. If, now, the analog input voltage Vin is larger than or equal to the reference voltage V2 and smaller than the reference voltage V3 (V2≦Vin<V3), then, in the comparator B13;

> transistor Q1 is ON
> transistor Q2 is OFF
> and in the comparator B33;
> transistor Q1 is ON
> transistor Q2 is OFF

Collector currents I0 and I0 flow to these transistors Q1 and Q1 due to the constant current sources Q0 and Q0 which are connected to the emitters thereof so that a current 2I0 flows through the resistor r which is connected to the base of the transistor Q11 in the comparator N11. Since the constant current from the constant current source Q20 is 1.5 I0, signals n11="H" and $\overline{\text{n11}}$="L" are obtained.

Although the transistors Q2 and Q2 in the comparators B13 and B33 are made OFF, due to the constant current source Q0, the current I0 flows through the resistor r connected to the base of the transistor Q11 in the comparator N12 so that n12="L" and $\overline{\text{N12}}$="H" are established.

> In the comparator B12;
> transistor Q1 is ON
> transistor Q2 is OFF
> and in the comparator B32;
> transistor Q1 is ON
> transistor Q2 is OFF

thus, similarly, signals n21="H", $\overline{\text{n21}}$="L", n22="L" and $\overline{\text{n22}}$="H" are obtained, respectively

> In the comparator B11;
> transistor Q1 is OFF
> transistor Q2 is ON
> and in the comparator B31;
> transistor Q1 is ON
> transistor Q2 is OFF

thus, due to the transistor Q1 in the comparator B31, the current I0 flows through the resistor r connected to the base of the transistor Q11 in the comparator N31 so that signals n31="L" and $\overline{\text{n31}}$="H" are obtained.

Due to the transistor Q2 in the comparator B11 and the constant current source Q0, a current 2I0

flows through the resistor r connected to the base of the transistor Q11 in the comparator N32 so that signals n32="H" and $\overline{\text{n32}}$="L" are established.

> In the comparators B21 to B23'
> transistor Q1 is OFF
> transistor Q2 is ON
> and in the comparators B41 to B43;
> transistor Q1 is ON
> transistor Q2 is OFF

Accordingly, due to the transistors Q1 in the comparators B41 to B43, a current I0 flows through the resistors r connected to the bases of the transistors Q11 in the comparators N41, N51 and N61, while due to the transistors Q2 in the comparators B21 to B23 and the constant current sources Q0 a current of 2I0 flows through the resistors r connected to the bases of the transistors Q12 in the comparators N42, N52 and N62, thus giving rise to signals

$$n41="L" \text{ and } \overline{n41}="H"$$

$$n42="H" \text{ and } \overline{n42}="L"$$

$$n51="L" \text{ and } \overline{n51}="H"$$

$$n52="H" \text{ and } \overline{n52}="L"$$

$$n61="L" \text{ and } \overline{n61}="H"$$

$$n62="H" \text{ and } \overline{n62}="L"$$

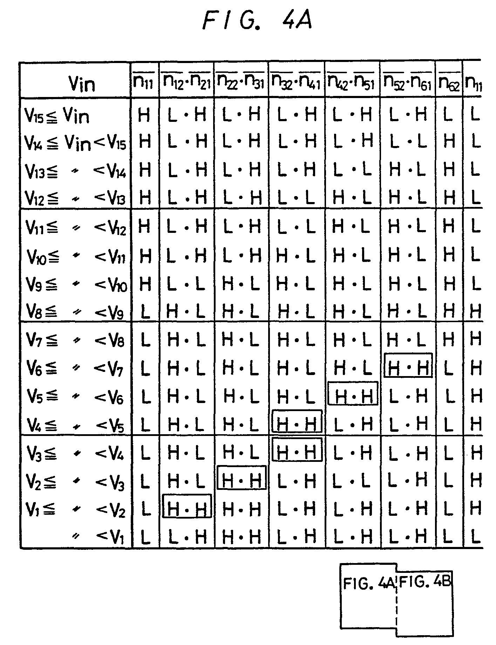

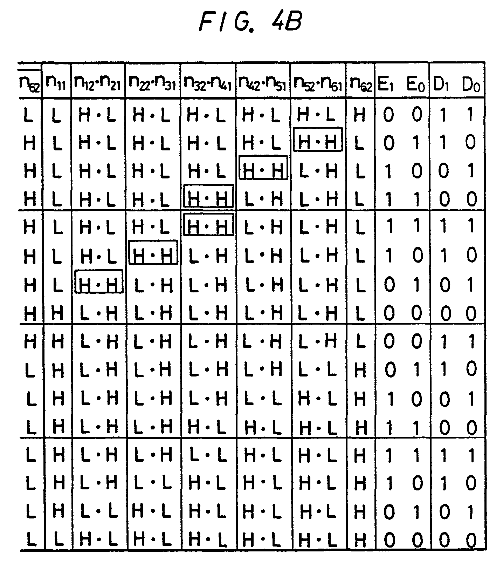

When these signals n11 to n62 are applied to suitable wired-AND logic, as shown in 3rd row from the bottom of the table of Fig. 4A and B, only an AND signal $\overline{n22}.\overline{n31}$ are "H" and all other AND signals are "L".

Since the AND signal $\overline{n22}.\overline{n31}$ that is represented by "H" is supplied to the transistor X1, E1=1 and E0="0" are established. Therefore, when the analog input voltage Vin is greater than or equal to V2 and smaller than V3 (V2≦Vin<V3), D2="0" is achieved as shown in the table of Fig. 3 so that D1=E1 and D0=E0 are satisfied in the control circuit INV. When the condition of V2≦Vin<V3 is satisfied, D3="0" is established as shown in the table of Fig. 3.

Thus, the condition of V2≦Vin<V3 yields D3 to D0="0010". Since the analog input voltage Vin is at a level corresponding to the second step counted from the ground side (ground potential is assumed to be at the 0-th step level) and 2="0010" is achieved, the digital output D3 to D0="0010" is correct.

Similarly, the analog input voltage Vin, the signals n11 to $\overline{\text{n62}}$, the emitter outputs E0 and E1, and the lower bits D1 and D0 are given as those shown by the table of Figs. 4A and 4B. Only the AND signals within the signals n11 to $\overline{\text{n62}}$ that correspond to the level of the input voltage Vin become "H" and so the correct digital output D3 to D0 can be obtained.

As described above, according to the A/D converter of the invention, the reference voltages V15 to V0 are separated to four groups of voltages V15 to V12, V11 to V8, V7 to V4 and V3 to V0 and the voltages V12, V8, V4 (and V0) each of which represents the lowest voltage in each group are compared with the analog input voltage Vin thereby producing upper 2 bits D3 and D2 of the digital output D3 to D0. The reference voltages V15 to V0 which were utilized to generate the upper bits D3 and D2 are compared in voltage with the analog input voltage Vin to derive lower 2 bits D1 and D0 of the digital output D3 to D0. Therefore, upon A/D conversion, no errors occur in the transition between the upper bits D3 and D2 and the lower bits D1 and D0, thus resulting in A/D conversion with high precision.

Furthermore, the comparators A3 to A1 and Bij inherently function as the first stages of the comparators M3 to M1 and N6 to N1 and the encoders ENCN are of a simple arrangement. According, as is clear from Figs. 1A to 1D and 2A to 2D, the number of circuit elements is reduced, and so this leads to improved economy of power consumption and smaller chip size for the IC.

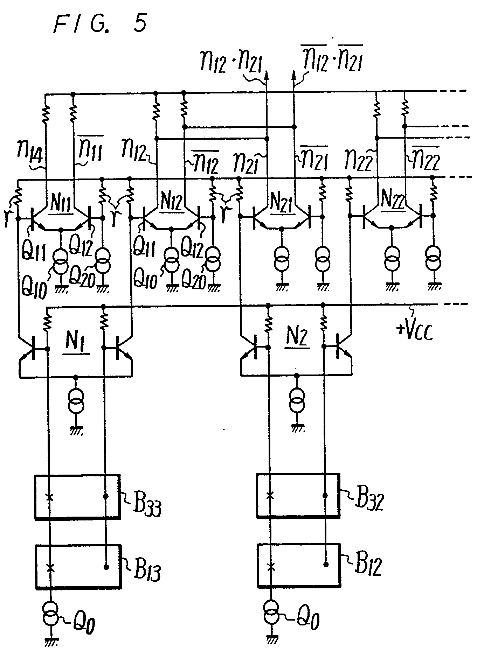

While in the description as set forth above the outputs from the comparators Bij are directly supplied to the comparators N11 to N62, it is also possible that as shown in Fig. 5, the comparators N1 to N6 and N11 to N62 may be independently formed whereby the outputs from the comparators Bij may be defined as "H"s and "I"s in the comparators N1 to N6 and then conveyed to the comparators N11 to N62.

## Claims

1. An analog-to-digital converter for converting an analog input signal to a digital output signal with m upper bits and n lower bits having $(2^{m+n}-1)$ resistor means connected in a series circuit to establish respective reference voltages, comprising; $(2^m-1)$ upper bits comparator circuits having first input terminals connected to receive said analog input signal and second input terminals connected to said series circuit of resistor means at $2^n$ intervals defining $2^n$ groups of resistor means therebetween; upper bits encoder means connected to receive said output signals of said $(2^m-1)$ upper bit(s) comparator circuits for generating said m upper bits wherein lower bits encoder means are connected to a lower bits matrix comparator circuit for generating said n lower bits, a lower bits matrix comparator circuit having $2^m(2^n-1)$ comparators having first input terminals which are connected to receive said analog input signal and second input terminals which are connected to respective nodes of said series circuit of resistor means except for a plurality of nodes of said resistor means to which said second input terminals of said $(2^m-1)$ upper bit(s) comparators are connected.

2. An analog-to-digital converter according to claim 1, further comprising a wired logic circuit between said lower bits matrix comparator circuit and said lower bits encoder means for deriving the lower order bits of the converted signal.

3. An analog-to-digital converter according to claim 2, in which said wired logic circuits are wired-AND circuits.

4. An analog-to-digital converter according to claim 3, in which said wired-AND circuits are formed with respective pairs of comparators respectively.

5. An analog-to-digital converter according to any one of the preceding claims wherein said lower bits matrix comparator circuit are each supplied with a current $I_0$ by respective one of a plurality of current sources.

6. An analog-to-digital converter according to claims 4 and 5 in which one of the input terminals of one of said pair of comparators is supplied by a current source with a current $1.5 I_0$.

7. An analog-to-digital converter according to any one of the preceding claims in which said upper bits comparator circuits have pre-comparators and main comparators.

8. An analog-to-digital converter according to any one of the preceding claims, in which said resistor means are resistors.

9. An analog-to-digital converter according to any one of the preceding claims in which said upper bits encoder and said lower bits encoder are constructed with bipolar transistors.

## Patentansprüche

1. Analog/Digital-Wandler zum Umsetzen eines analogen Eingangssignals in ein digitales Ausgangssignal mit m höheren Bits und n niedrigeren Bits,
der $(2^{m+n}-1)$ Widerstandseinrichtungen aufweist, die in Reihe geschaltet sind, um jeweilige Bezugsspannungen zu erreichen, sowie
$(2^m-1)$ Vergleicherschaltungen für höhere Bits, deren erste Eingangsanschlüsse zum Empfang des analogen Eingangssignals angeschlossen sind und deren zweite Eingangsanschlüsse mit der Reihenschaltung der Widerstandseinrichtungen in $2^n$ Intervallen angeschlossen sind, die $2^n$ Gruppen von Widerstandseinrichtungen zwischen sich definieren,
mit einer Codiereinrichtung für höhere Bits, die zum Empfang der Ausgangssignale der $(2^m-1)$ Vergleicheinrichtungen für höhere Bits verbunden ist zum Erzeugen der m höheren Bits,
wobei eine Codiereinrichtung für niedrigere Bits mit einer Matrix-Vergleicherschaltung für niedrigere Bits zum Erzeugen der n niedrigeren Bits verbunden ist,
wobei die Matrix-Vergleicherschaltung für niedrigere Bits $2^m (2^n-1)$ Vergleicher aufweist, bei denen erste Eingangsanschlüsse zum Empfang des analogen Eingangssignals angeschlossen sind und zweite Eingangsanschlüsse mit jeweiligen Verbindungspunkten der Reihenschaltung der Widerstandseinrichtungen verbunden sind, mit der Ausnahme mehrerer Verbindungspunkte der Widerstandseinrichtungen, mit denen die zweiten Eingangsanschlüsse der $(2^m-1)$ Vergleicherschaltungen für höhere Bits verbunden sind.

2. Analog/Digital-Wandler nach Anspruch 1, der ferner eine verdrahtete Logikschaltung zwischen der Matrix-Vergleicherschaltung für niedrigere Bits und der Codiereinrichtung für niedrigere Bits aufweist, zur Abgabe der Bits niedrigerer Ordnung des umgesetzten Signals.

3. Analog/Digital-Wandler nach Anspruch 2, dadurch gekennzeichnet, daß die verdrahteten Logikschaltungen durch verdrahtete UND-Schaltungen gebildet sind.

4. Analog/Digital-Wandler nach Anspruch 3, bei dem die verdrahteten UND-Schaltungen jeweils mit jeweiligen Paaren von Vergleichern gebildet sind.

5. Analog/Digital-Wandler nach einem der vorhergehenden Ansprüche, bei dem die Matrix-Vergleicherschaltung für niedrigere Bits jeweils mit einem Strom $I_0$ durch entsprechende von mehreren Stromquellen versorgt ist.

6. Analog/Digital-Wandler nach den Ansprüchen 4 und 5, bei dem einer der Engangsanschlüsse von einem der Paare der Vergleicher von einer Stromquelle mit einem Strom von 1,5 $I_0$ versorgt ist.

7. Analog/Digital-Wandler nach einem der vorhergehenden Ansprüche, bei dem die Vergleicherschaltungen für höhere Bits Vor-Vergleicher und Haupt-Vergleicher aufweisen.

8. Analog/Digital-Wandler nach einem der vorhergehenden Ansprüche, bei dem die Widerstandseinrichtungen Widerstände sind.

9. Analog/Digital-Wandler nach irgendeinem der vorhergehenden Ansprüche, bei dem die Codiereinrichtung für höhere Bits und die Codiereinrichtung für niedrigere Bits mittels bipolarer Transistoren aufgebaut sind.

**Revendications**

1. Convertisseur analogique-numérique servant à convertir un signal d'entrée analogique en un signal de sortie numérique à $m$ bits supérieurs et $n$ bits inférieurs qui comporte $(2^{m+n}-1)$ moyens résistants connectés en un circuit série afin d'établir des tensions de référence respectives, comprenant: $2^m-1)$ circuits comparateurs de bits supérieurs dont des premières bornes d'entrée sont connectées de façon à recevoir ledit signal d'entrée analogique et des deuxièmes bornes d'entrée sont connectées audit circuit série de moyens résistants en $2^n$ intervalles définissant entre eux $2^n$ groupes de moyens résistants; des moyens codeurs de bits supérieurs connectés de façon à recevoir lesdits signaux de sortie desdits

$(2^m-1)$ circuits comparateurs de bit(s) supérieur(s) afin de produire lesdits $m$ bits supérieurs, où des moyens codeurs de bits inférieurs sont connectés à un circuit comparateur matriciel de bits inférieurs afin de produire lesdits $n$ bit inférieurs, un circuit comparateur matriciel de bits inférieurs ayant $2^m(2^n-1)$ comparateurs dont des premières bornes d'entrée sont connectées de façon à recevoir ledit signal d'entrée analogique et des deuxièmes bornes d'entrée sont connectées à des noeuds respectifs dudit circuit série de moyens résistants, à l'exception des différents noeuds desdits moyens résistants auxquels lesdites deuxièmes bornes d'entrée desdits $(2^m-1)$ comparateurs de bit(s) supérieur(s) sont connectées.

2. Convertisseur analogique-numérique selon la revendication 1, comprenant en outre un circuit logique câble entre ledit circuit comparateur matriciel de bits inférieurs et lesdits moyens codeurs de bits inférieurs afin de produire les bits d'ordre inférieur du signal résultant de la conversion.

3. Convertisseur analogique-numérique selon la revendication 2, dans lequel lesdits circuits logiques câblés sont des circuits ET câblés.

4. Convertisseur analogique-numérique selon la revendication 3, dans lequel lesdits circuits ET câblés sont respectivement formés avec des paires respectives de comparateurs.

5. Convertisseur analogique-numérique selon l'une quelconque des revendications précédentes, où ledit circuit comparateur matriciel de bits inférieurs reçoit respectivement des courants $I_0$ de la part de plusieurs sources de courant respectives.

6. Convertisseur analogique-numérique selon les revendications 4 et 5, dans lequel l'une des bornes d'entrée de l'un des comparateurs de ladite paire de comparateurs reçoit un courant de 1,5 $I_0$ de la part d'une source de courant.

7. Convertisseur analogique-numérique selon l'une quelconque des revendications précédentes, dans lequel lesdits circuits comparateurs de bits supérieurs possèdent des pré-comparateurs et des comparateurs principaux.

8. Convertisseur analogique-numérique selon l'une quelconque des revendications précédentes, dans lequel lesdits moyens résistants sont des résistances.

9. Convertisseur analogique-numérique selon l'une quelconque des revendications précédentes, dans lequel ledit codeur de bits supérieurs et ledit codeur de bits inférieurs sont construits avec des transistors bipolaires.

# EP 0 082 736 B1

## F I G. 1A

1

FIG. 1B

FIG. 1C

FIG. 1D

FIG. 2A

FIG. 2B

FIG. 2C

EP 0 082 736 B1

EP 0 082 736 B1

FIG. 2D

8

FIG. 3A     FIG. 3B        FIG. 3C  FIG. 3D

| Vin | $m_1$ | $\overline{m}_1$ | $m_2$ | $\overline{m}_2$ | $m_3$ | $\overline{m}_3$ | $m_1$ | $\overline{m}_1 + m_2$ | $\overline{m}_2 + m_3$ | $\overline{m}_3$ | $D_3$ | $D_2$ |
|---|---|---|---|---|---|---|---|---|---|---|---|---|
| $V_{15} \leqq V_{in}$ | H | L | H | L | H | L | H | H | H | L | | |
| $V_{14} \leqq V_{in} < V_{15}$ | H | L | H | L | H | L | H | H | H | L | 1 | 1 |
| $V_{13} \leqq \ast < V_{14}$ | H | L | H | L | H | L | H | H | H | L | | |
| $V_{12} \leqq \ast < V_{13}$ | H | L | H | L | H | L | H | H | H | L | | |
| $V_{11} \leqq \ast < V_{12}$ | H | L | H | L | L | H | H | H | L | H | | |
| $V_{10} \leqq \ast < V_{11}$ | H | L | H | L | L | H | H | H | L | H | 1 | 0 |
| $V_9 \leqq \ast < V_{10}$ | H | L | H | L | L | H | H | H | L | H | | |
| $V_8 \leqq \ast < V_9$ | H | L | H | L | L | H | H | H | L | H | | |
| $V_7 \leqq \ast < V_8$ | H | L | L | H | L | H | H | L | H | H | | |
| $V_6 \leqq \ast < V_7$ | H | L | L | H | L | H | H | L | H | H | 0 | 1 |
| $V_5 \leqq \ast < V_6$ | H | L | L | H | L | H | H | L | H | H | | |
| $V_4 \leqq \ast < V_5$ | H | L | L | H | L | H | H | L | H | H | | |
| $V_3 \leqq \ast < V_4$ | L | H | L | H | L | H | L | H | H | H | | |
| $V_2 \leqq \ast < V_3$ | L | H | L | H | L | H | L | H | H | H | 0 | 0 |
| $V_1 \leqq \ast < V_2$ | L | H | L | H | L | H | L | H | H | H | | |
| $\ast < V_1$ | L | H | L | H | L | H | L | H | H | H | | |

## F I G. 4A

| Vin | $\overline{n_{11}}$ | $\overline{n_{12}}\cdot\overline{n_{21}}$ | $\overline{n_{22}}\cdot\overline{n_{31}}$ | $\overline{n_{32}}\cdot\overline{n_{41}}$ | $\overline{n_{42}}\cdot\overline{n_{51}}$ | $\overline{n_{52}}\cdot\overline{n_{61}}$ | $\overline{n_{62}}$ | $n_{11}$ |
|---|---|---|---|---|---|---|---|---|
| $V_{15} \leqq V_{in}$ | H | L·H | L·H | L·H | L·H | L·H | L | L |
| $V_{14} \leqq V_{in} < V_{15}$ | H | L·H | L·H | L·H | L·H | L·L | H | L |
| $V_{13} \leqq$ ″ $< V_{14}$ | H | L·H | L·H | L·H | L·L | H·L | H | L |
| $V_{12} \leqq$ ″ $< V_{13}$ | H | L·H | L·H | L·L | H·L | H·L | H | L |
| $V_{11} \leqq$ ″ $< V_{12}$ | H | L·H | L·H | L·L | H·L | H·L | H | L |
| $V_{10} \leqq$ ″ $< V_{11}$ | H | L·H | L·H | H·L | H·L | H·L | H | L |
| $V_{9} \leqq$ ″ $< V_{10}$ | H | L·L | H·L | H·L | H·L | H·L | H | L |
| $V_{8} \leqq$ ″ $< V_{9}$ | L | H·L | H·L | H·L | H·L | H·L | H | H |
| $V_{7} \leqq$ ″ $< V_{8}$ | L | H·L | H·L | H·L | H·L | H·L | H | H |
| $V_{6} \leqq$ ″ $< V_{7}$ | L | H·L | H·L | H·L | H·L | [H·H] | L | H |
| $V_{5} \leqq$ ″ $< V_{6}$ | L | H·L | H·L | H·L | [H·H] | L·H | L | H |
| $V_{4} \leqq$ ″ $< V_{5}$ | L | H·L | H·L | [H·H] | L·H | L·H | L | H |
| $V_{3} \leqq$ ″ $< V_{4}$ | L | H·L | H·L | [H·H] | L·H | L·H | L | H |
| $V_{2} \leqq$ ″ $< V_{3}$ | L | H·L | [H·H] | L·H | L·L | L·H | L | H |
| $V_{1} \leqq$ ″ $< V_{2}$ | L | [H·H] | H·H | L·H | L·H | L·H | L | H |
| ″ $< V_{1}$ | L | L·H | H·H | L·H | L·H | L·H | L | L |

FIG. 4A | FIG. 4B

## FIG. 4B

| $\overline{n_{62}}$ | $n_{11}$ | $n_{12} \cdot n_{21}$ | $n_{22} \cdot n_{31}$ | $n_{32} \cdot n_{41}$ | $n_{42} \cdot n_{51}$ | $n_{52} \cdot n_{61}$ | $n_{62}$ | $E_1$ | $E_0$ | $D_1$ | $D_0$ |
|---|---|---|---|---|---|---|---|---|---|---|---|
| L | L | H·L | H·L | H·L | H·L | H·L | H | 0 | 0 | 1 | 1 |
| H | L | H·L | H·L | H·L | H·L | [H·H] | L | 0 | 1 | 1 | 0 |
| H | L | H·L | H·L | H·L | [H·H] | L·H | L | 1 | 0 | 0 | 1 |
| H | L | H·L | H·L | [H·H] | L·H | L·H | L | 1 | 1 | 0 | 0 |
| H | L | H·L | H·L | [H·H] | L·H | L·H | L | 1 | 1 | 1 | 1 |
| H | L | H·L | [H·H] | L·H | L·H | L·H | L | 1 | 0 | 1 | 0 |
| H | L | [H·H] | L·H | L·H | L·H | L·H | L | 0 | 1 | 0 | 1 |
| H | H | L·H | L·H | L·H | L·H | L·H | L | 0 | 0 | 0 | 0 |
| H | H | L·H | L·H | L·H | L·H | L·H | L | 0 | 0 | 1 | 1 |
| L | H | L·H | L·H | L·H | L·H | L·L | H | 0 | 1 | 1 | 0 |
| L | H | L·H | L·H | L·H | L·L | H·L | H | 1 | 0 | 0 | 1 |
| L | H | L·H | L·H | H·L | H·L | H·L | H | 1 | 1 | 0 | 0 |
| L | H | L·H | L·H | L·L | H·L | H·L | H | 1 | 1 | 1 | 1 |
| L | H | L·H | L·L | H·L | H·L | H·L | H | 1 | 0 | 1 | 0 |
| L | H | L·L | H·L | H·L | H·L | H·L | H | 0 | 1 | 0 | 1 |
| L | L | H·L | H·L | H·L | H·L | H·L | H | 0 | 0 | 0 | 0 |

F I G. 5